# EUROPEAN PATENT APPLICATION

(11) **EP 0 587 129 A1**
(43) Date of publication of application: **16.03.1994**
(21) Application number: 93114360.6
(22) Date of filing: 07.09.1993
(51) Int. Cl.: H04B 1/26, H03D 7/16

(54) **Receiver for digital mobile communications**

(30) Priority: 11.09.1992 JP 243173/92
(71) Applicant: NTT MOBILE COMMUNICATIONS NETWORK INC., Minato-ku, Tokyo (JP)
(72) Inventor: Takami, Tadao, Yokosuka-shi, Kanagawa (JP); Shimizu, Isao, Yokosuka-shi, Kanagawa (JP); Chiba, Kohji, Yokohama-shi, Kanagawa (JP)
(74) Representative: Hoffmann, Eckart, Dipl.-Ing.

(57) **Abstract**

A received digital phase-modulated signal is converted by a first frequency converter (13) into a first intermediate-frequency signal, which is applied to a first intermediate-frequency filter (22) which approximates a square-root Nyquist cosine roll-off characteristic and in which intersymbol interference and interference of adjacent-channel signals are suppressed. That is, the first intermediate-frequency signal is subjected to shaping of its spectrum and channel filtering. The first intermediate-frequency filter (22) is formed by a monolithic crystal filter which utilizes the fundamental resonance mode of an AT-cut crystal element. The output from the first intermediate-frequency filter (22)is converted by a second frequency converter (16) to a second intermediate-frequency signal. The second intermediate-frequency signal is applied to a second intermediate-frequency filter (23) of a band pass or low-pass characteristic, wherein noise such as a leakage signal of a second local oscillator (15) is removed from the second intermediate-frequency signal. The output from the second intermediate-frequency filter (23) is supplied to a limiter (18) and thence to a demodulator (19).

## Description

### BACKGROUND OF THE INVENTION

The present invention relates to a receiver which is used in a digital mobile communication system to receive a digital phase-modulated signal through utilization of a double superheterodyne system.

To make effective use of a limited frequency bandwidth in a communication system which uses a digital phase-modulated signal as an information transfer medium, it is a general practice in the art to shape the spectrum of the transmission signal by a band-limiting filter prior to the transmission of the signal so as to avoid interference of adjacent-channel signals. The band-limiting filter has, as its transmission characteristic, for example, a Nyquist raised cosine roll-off characteristic to prevent intersymbol interference in the received signal. In this instance, the band-limiting filter at the transmitter side and the band-limiting filter at the receiver side are usually square-root Nyquist roll-off filters of the type that the Nyquist raised cosine roll-off characteristic is shared equally by the transmitter side and the receiver side.

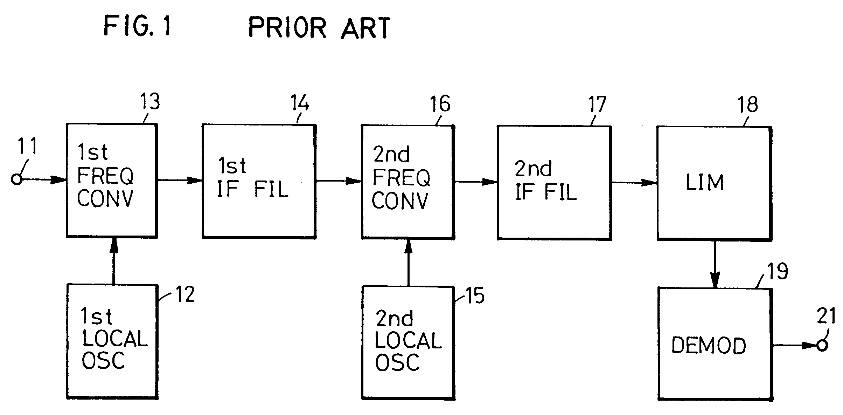

Fig. 1 shows, in block diagram, an ordinary receiver (a double conversion type superheterodyne receiver) which has heretofore been used for digital mobile communications. A digital phase-modulated signal input via a receiving input terminal 11 is applied to a first frequency converter 13, wherein it is frequency converted by the output of a first local oscillator 12 into a first intermediate-frequency signal. The first intermediate-frequency signal is band limited by a first intermediate-frequency filter 14 and then provided to a second frequency converter 16, wherein it is frequency converted by the output of a second local oscillator 15 into a second intermediate-frequency signal. The second intermediate-frequency signal thus obtained is further band limited by a second intermediate-frequency filter 17, thereafter being amplified and limited in amplitude by a limiter 18. The limiter output is detected and demodulated by a demodulator 19 and the demodulated digital signal is provided to an output terminal 21.

The above-described conventional receiver for digital mobile radio communications usually employs a surface acoustic wave filter (hereinafter referred to as a SAW filter) as the first intermediate-frequency filter 14 and a ceramic filter as the second intermediate-frequency filter 17. Conventionally, the receiver for digital mobile radio communications, whose radio channel is, for example, 800 MHz band, utilizes a frequency in a range of 90 to 130 MHz as the first intermediate frequency and 455 kHz or so as the second intermediate frequency.

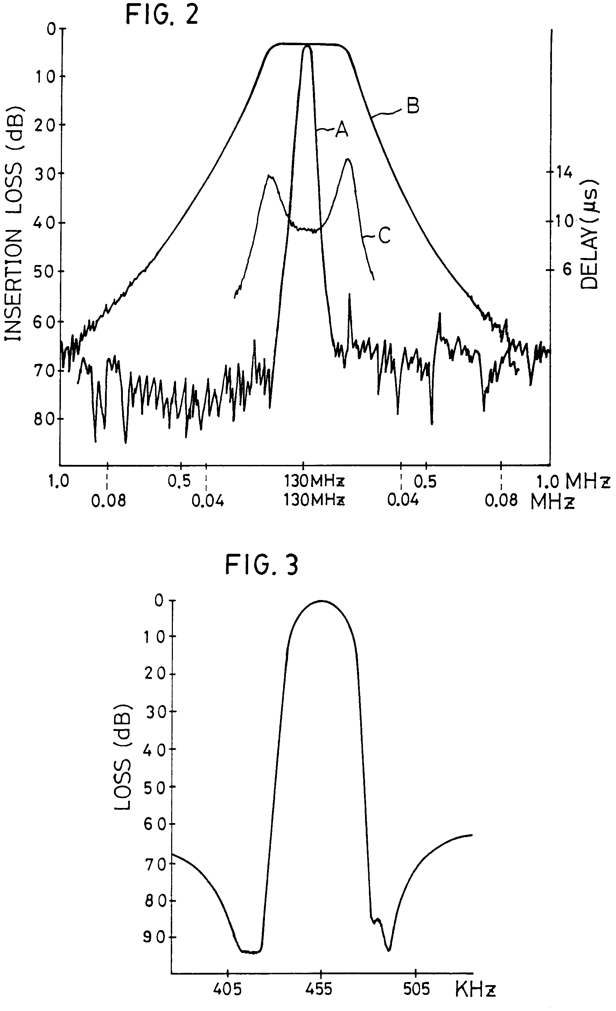

In Fig. 2 there is shown, by the curve A, an example of the attenuation characteristic of the first intermediate-frequency filter 14 formed by a SAW filter. The curve B shows the attenuation characteristic of the curve A, with the frequency axis enlarged, and the curve C the group delay characteristics of the SAW filter with respect to the enlarged frequency axis. The SAW filter is used because it facilitates implementation of desired characteristics in high frequency bands, and the primary function of the SAW filter used as the first intermediate-frequency filter 14 is to suppress image signals at the second intermediate-frequency that is inevitable in the superheterodyne receiver formed by the second frequency converter 16 and the subsequent stages. For example, in the case where the first intermediate-frequency, the second intermediate-frequency and the local oscillation frequency of the second local oscillator 15 are 130 MHz, 455 kHz and 129.545 MHz, respectively, signals not only in the 130 MHz band but also in a 129.090 MHz band, lower than the local oscillation frequency by 455 kHz, will fall into the second intermediate-frequency band. To avoid this, the first intermediate-frequency filter 14 needs to attenuate the 129.090 MHz band down to a value smaller than a prescribed one (70 dB, for instance).

Since the characteristics of the SAW filter are susceptible to a temperature change, it is necessary that its pass bandwidth be set to about ±20 KHz, with a 3 dB-down definition, somewhat wider than the receiving signal band of, for example, ±10.5 KHz to prevent the received signal from being distorted by a change in the center frequency which is caused by a temperature change. The SAW filter 14 is designed so that its characteristics in the passband are flat and substantially free from ripples, as indicated by the curve B in Fig. 2. That is, the conventional first intermediate-frequency filter 14 has no channel filtering function which is needed to suppress the intersymbol interference of the received signal and the interference of adjacent-channel signals. These functions are performed by the second intermediate-frequency filter 17.

Fig. 3 is a graph showing one example of the attenuation characteristics of the second intermediate-frequency filter 17 formed by a ceramic filter. The primary object of the ceramic filter used as the second intermediate-frequency filter 17 is the channel filtering of the received signal so as to suppress the intersymbol interference of the received signal, and as shown with the frequency axis enlarged, the amplitude characteristic in the pass band is approximate to a square-root Nyquist cosine roll-off characteristic. As regards the filter characteristic approximate to the square-root Nyquist cosine roll-off characteristic, it is well-known that the square-root Nyquist cosine roll-off characteristic can be approximated by finite-order band-pass filters such as ceramic filters, as disclosed in, for example. An Approximate Nyquist Transmission for QPSK Digital Mobile Communication," Takami et al., Journal of Institute of Electronics and Communication Engineers of Japan, B-II, Vol. J74-B-II, No. 7, July 1991, pp. 405-412.

Since the first intermediate-frequency filter 14, formed by the SAW device, does not achieve a required attenuation in adjacent channels, for example, 70 dB or more as shown in Fig. 2, the second intermediate-frequency filter 17 needs to have the function of eliminating the interference of adjacent-channel signals as well as the intersymbol interference eliminating function by the square-root Nyquist cosine roll-off characteristic. For this reason, the second intermediate-frequency filter 17 is required to provide an attenuation of 70 dB or more in adjacent channels as depicted in Fig. 3. To attain such a high selectivity, a multi-element ceramic filter composed of eight or more elements is requisite -- this leads to a defect that the second intermediate-frequency filter 17 is inevitably bulky. The ceramic filter for use as the second intermediate-frequency filter 17 is a passive device, and hence will not increase the power consumption of the receiver. Therefore, this conventional receiver permits remarkable reduction of the power dissipation and circuit scale as compared with a receiver of the type having the square-root Nyquist cosine roll-off filter formed by an active filter or digital filter.

Moreover, since the intersymbol interference is suppressed in advance by the square-root Nyquist cosine roll-off spectral shaping in the second intermediate-frequency band, nonlinear amplification of the received signal by limiter amplifier is possible; thus, the conventional receiver has the construction of a digital receiver that is small in power consumption but has a wide dynamic range.

In mobile radio communications the receiving level and the phase of the received signal substantially vary at random owing to Rayleigh fading, and consequently, data errors of the received signal are unavoidable, presenting a problem that the transmission performance is impaired. One technique that has been proposed as a solution to this problem is a diversity reception. In the diversity reception, antennas and receivers of a plurality of branches are disposed so that the correlation between respective received signal levels may be reduced to zero, and a branch in an excellent receiving condition is selected or the received signals of the respective branches are combined, whereby the data errors are effectively diminished.

In the field of mobile radio communications there have recently been severe requirements for miniaturization of portable telephones, and to meet the requirements for miniaturization, parts of receivers for the portable telephone are now being switched to surface mounting type devices. In the conventional receiver for digital radio communications which shapes the spectrum of the received signal by the second intermediate-frequency filter 17, however, the ceramic filter for use as the second intermediate-frequency filter 17 is required of high selectivity (a sharp or steep attenuation characteristic) and is inevitably multi-element, and hence is difficult of miniaturization -- this constitutes a serious obstacle to micro-miniaturization of the entire receiver structure. Thus, it is impractical, in the conventional portable telephone, to employ a plurality of receivers for diversity reception, because it will hinder the miniaturization of the telephone.

Furthermore, the number of fading of the received signal level per unit time in Rayleigh fading tends to increase in proportion to the carrier frequency of the received signal. For example, in a digital mobile radio communication systems which utilizes a frequency band above 1.5 GHz band, expected to come into use in the future, the number of fading of the received signal level per unit time is more than about twice larger than in the 800 MHz band used in the past, and consequently, a larger data errors are induced. This poses a problem that stable channel quality cannot be obtained when no diversity reception is utilized. As a solution to this problem, the realization of a small receiver has been eagerly demanded which would permit application of the diversity reception to the portable telephone as well.

### SUMMARY OF THE INVENTION

It is therefore an object of the present invention to provide a receiver for digital mobile radio communications which solves the above-mentioned problems of the prior art and permits miniaturization, reduction of its power consumption and widening of its dynamic range.

The receiver according to the present invention includes: first local oscillator means for generating a first local signal; first frequency converter means which mixes the first local signal with a received digital phase-modulated signal to obtain a first intermediate-frequency signal; first intermediate-frequency filter means which has an approximate square-root Nyquist cosine roll-off characteristic for suppressing intersymbol interference of the first intermediate-frequency signal from the first frequency converter means and a channel filtering characteristic for suppressing interference of adjacent-channel signals; second local signal generator means for generating a second local signal; second frequency converter means which mixes the output of the first intermediate-frequency filter means to obtain a signal of a desired frequency band lower than that of the first intermediate-frequency signal; and means for demodulating the output of the second frequency converter means.

The receiver of the present invention may also be provided with a second intermediate-frequency filter for eliminating noise contained in the output signal of the second frequency converter means.

In this receiver it is also possible to employ a construction in which the second frequency converter means directly converts the first intermediate-frequency signal, by two second local signals 90° of which phase difference is 90 degrees, into two base band signals for demodulation.

According to the present invention, the first intermediate-frequency filter means has a pass-band amplitude characteristic approximate to a square-root Nyquist cosine roll-off characteristic and a characteristic for shaping the spectrum of the received signal, and hence the first intermediate-frequency filter means suppresses intersymbol interference of the received signal while at the same time inhibits interference of adjacent-channel signals. Therefore, the afore-mentioned second intermediate-frequency filter need not be used. Even if the second intermediate-frequency filter is utilized, it is simple-structured since it is not required of a steep characteristic, and therefore, the filter can easily be fabricated as an IC. Alternatively, the first intermediate-frequency signal may be converted directly to a base band signal, in which case a low-pass filter of the base band can operate at lower frequencies, and hence is suitable for fabrication as an IC and reduces overall power dissipation.

### BRIEF DESCRIPTION OF THE DRAWINGS

Fig. 1 is a block diagram showing a conventional receiver for digital mobile radio communications;
Fig. 2 is a graph showing examples of the characteristics of a first intermediate-frequency filter for use in the receiver of Fig. 1;
Fig. 3 is a graph showing an examples of the characteristics of a second intermediate-frequency filter for use in the receiver of Fig. 1;
Fig. 4 is a block diagram illustrating an embodiment of the present invention;
Fig. 5 is a graph showing examples of the characteristics of a first intermediate-frequency filter for use in the receiver of Fig. 4;
Fig. 6 is a block diagram illustrating another embodiment of the present invention;
Fig. 7 is a graph showing examples of the characteristics of a second intermediate-frequency filter for use in the receiver of Fig. 6; and
Fig. 8 is a block diagram illustrating still another embodiment of the present invention.

### DESCRIPTION OF THE PREFERRED EMBODIMENTS

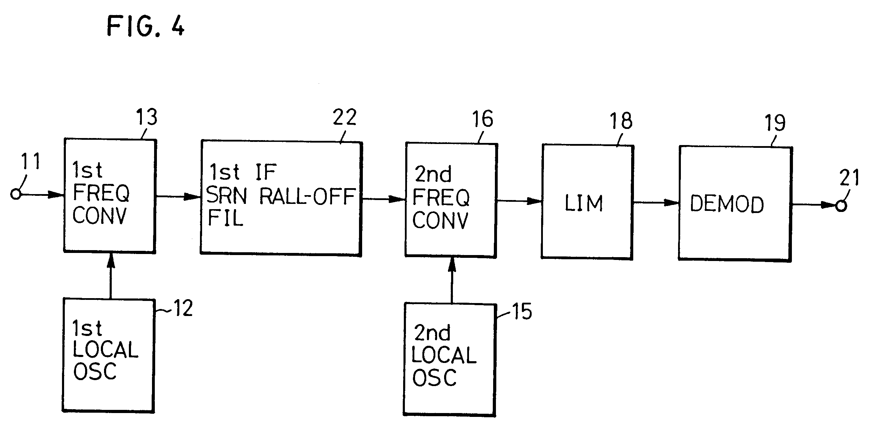

Fig. 4 illustrates, in block diagram, a first embodiment of the present invention, in which the parts corresponding to those in Fig. 1 are identified by the same reference numerals. In the present invention, the first intermediate-frequency signal from the first frequency converter 13 is applied to a first intermediate-frequency filter 22 which has an approximated square-root Nyquist cosine roll-off characteristic and in which the first intermediate-frequency signal spectrum is shaped into Nyquist roll-off characteristic. The output signal from the filter 22 is fed to the second frequency converter 16. The second intermediate-frequency signal, which is the output from the second frequency converter 16, is applied directly to the limiter 18, wherein it is amplified and limited in amplitude. The limiter output is detected and demodulated by the demodulator 19.

This embodiment has its feature in that the first intermediate-frequency filter 22 has a band-limiting characteristic which suppresses intersymbol interference of the first intermediate-frequency signal and interference of adjacent-channel signals. That is, the first intermediate-frequency filter 22 shapes the spectrum of the received signal into a desired waveform free from the intersymbol interference, while at the same time the filter shapes the spectrum of the received signal with respect to adjacent bands.

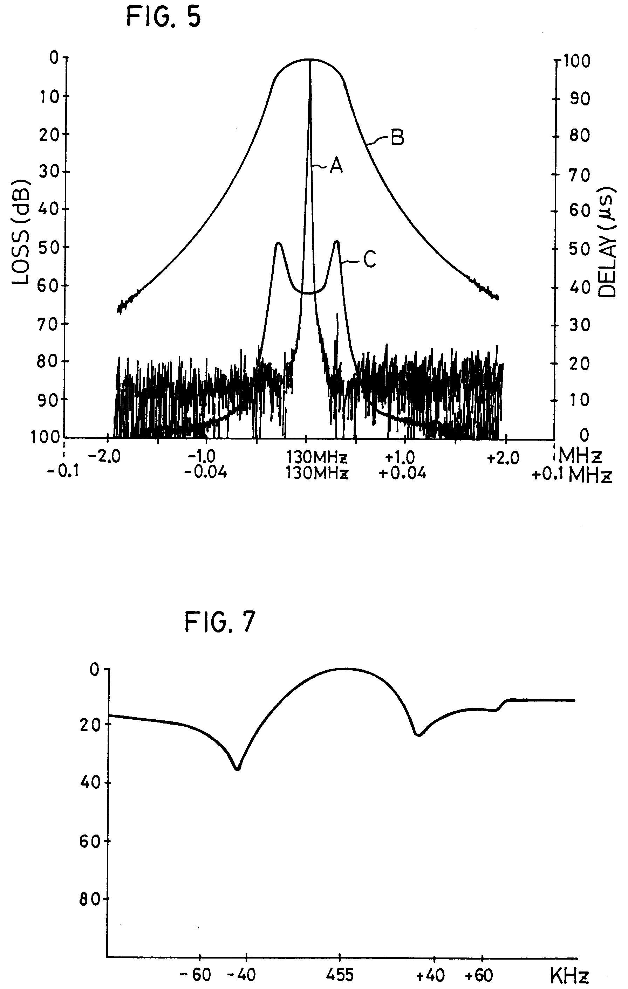

The first intermediate-frequency filter 22 has such attenuation characteristics as indicated by the curve A in Fig. 5 and shapes the spectrum of the received signal. The amplitude characteristic in the pass band approximates the square-root Nyquist cosine roll-off characteristic as indicated by the curve B with the frequency axis enlarged. The first intermediate-frequency filter 22 can be formed by, for instance, a monolithic crystal filter that utilizes the fundamental resonance mode of a crystal element. Since this filter allows reduction of the termination impedance, no external circuit is needed for impedance matching; accordingly, this filter can be made smaller than ordinary crystal filters. Moreover, this filter uses AT-cut crystal element, and hence has excellent frequency stability with respect to a temperature change. The monolithic crystal filter which utilizes the fundamental resonance mode of the crystal element is smaller in an out-of-band spurious response than a monolithic crystal filter using an overtone resonance mode and an out-of-band attenuation characteristic as large as more than 80 dB can be implemented over a frequency range of more than 20 MHz. Therefore, a sufficient selectivity characteristics are obtainable without using the second intermediate-frequency filter. Thus, this embodiment permits substantial miniaturization of the receiver.

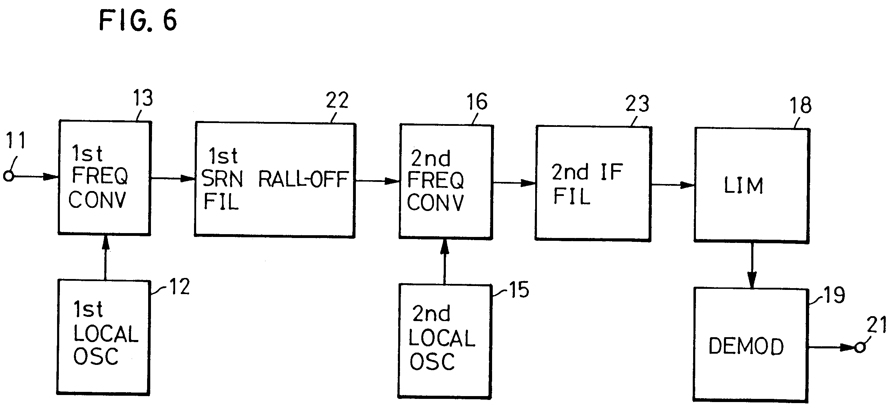

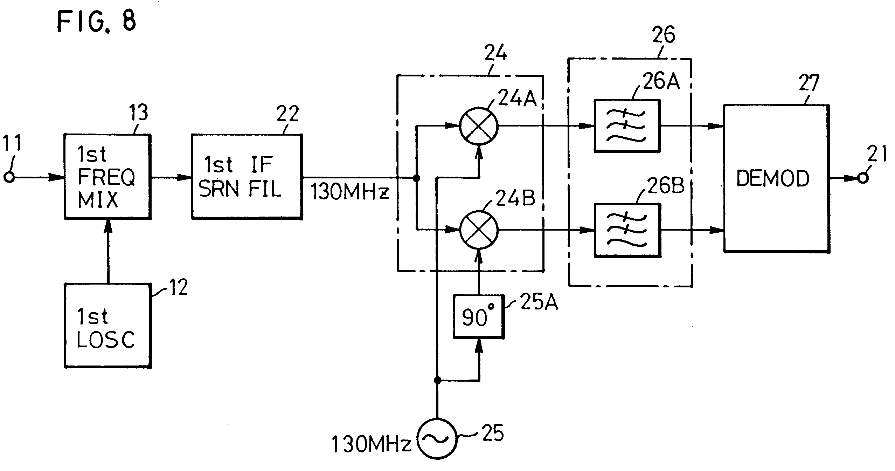

While in the above embodiment the second intermediate-frequency filter is not employed, it is a matter of course that the second intermediate-frequency filter may be used to further reduce out-of-band noise. An embodiment of such a construction is shown in Fig. 6, wherein the parts corresponding to those in Fig. 4 are identified by the same reference numerals. This embodiment differs from the Fig. 4 embodiment in that a second intermediate-frequency filter 23 is inserted between the second frequency converter 16 and the limiter 18. The second intermediate-frequency filter 23 eliminates noise which is contained in the output signal of the second frequency converter 16, such as a leak of the output signal of the second local oscillator 15. This prevents the limiter 18 of the subsequent stage from saturation by the out-of-band noise, improving the receiving sensitivity. The noise level in the output signal of the second frequency converter 16 is far lower than adjacent-channel interference signals. Hence, the need for the selectivity of the second intermediate-frequency filter 23 is less severe than in the case of the second intermediate-frequency filter 17 of the conventional receiver shown in Fig. 1, and a micro-miniature ceramic filter composed of two to four elements, as the second intermediate-frequency filter 23, is capable of sufficiently suppressing the noise. Fig. 7 shows an example of the attenuation characteristic of a two-element ceramic filter which is used as the second intermediate-frequency filter 23. As seen from Fig. 7, an attenuation of at least 10 dB or so is provided outside of the signal band (455±25 kHz).

The second intermediate-frequency filter 23 may be formed not only as a band pass filter but also as a low-pass filter which permits the passage of the signal frequencies below the second intermediate-frequency. That is, noise can sufficiently be suppressed even by a micro-miniature chip type low-pass filter formed by laminating LC elements, for example. This will therefore meet the both demands for miniaturization of the receiver and enhancement of its sensitivity. Furthermore, since the demand for the selectivity characteristic of the second intermediate-frequency filter 23 is far less severe than the demand for the square-root Nyquist cosine roll-off characteristic, an active filter, switched capacitor filter or similar filter can easily be used. Needless to say, a band pass filter or low-pass filter is applicable to the active filter, switched capacitor filter or the like as well. This also allows fabrication of the second intermediate-frequency filter 23 as an IC, enabling further miniaturization of the receiver and further enhancement of its sensitivity.

Fig. 8 illustrates still another embodiment of the present invention, which is common to the above-described embodiments in that a square-root Nyquist cosine roll-off filter with such a characteristic as shown in Fig. 5 is used as the first intermediate-frequency filter 22 which is supplied with the output from the first frequency converter 13. In this embodiment the second frequency converter 24 is to convert the signal of the first intermediate-frequency band (130 MHz, for example) directly to a base band signal, instead of converting the first intermediate-frequency signal to a second intermediate-frequency signal. To this end, the second local oscillator 25 generates a local signal of the same frequency as the center frequency of the intermediate-frequency band, for instance, 130 MHz. In this embodiment the second frequency converter 24 is made up of two mixers 24A and 24B. Supplied with the first intermediate-frequency signal, the second local signal and a local signal obtained by shifting the phase of the second local signal through 90 degrees by a phase shifter 25A, the mixers 24A and 24B perform frequency mixing. The outputs from the mixers 24A and 24B are provided to low-pass filters 26A and 26B which forms a filter circuit 26. As a result, base band signals are extracted and provided to a demodulator 27 for QPSK demodulation, for instance.

According to this embodiment, the filter circuit 26 handles the base band signal, and hence consumes less power than the second intermediate-frequency filter 23 in the Fig. 6 embodiment which handles the second intermediate-frequency signal as high as 455 kHz, besides the filter circuit 26 can easily be digitized. Hence, the filter circuit 26 can be fabricated as an IC together with the demodulator 27 -- this contributes to further miniaturization of the receiver.

As will be appreciated from the above, the present invention enables miniaturization of the receiver and reduction of its power dissipation, thus facilitating the implementation of diversity reception even in portable telephones where miniaturization and reduction of power dissipation are severely required. With the use of diversity reception, it is possible to enhance the sensitivity of a portable telephone for digital mobile radio communications which is used in an environment of drastic level changes by fading as in a 1.5 GHz band, for instance, and consequently, excellent channel quality can be secured.

As described above, according to the present invention, since the first intermediate-frequency filter suppresses intersymbol interference of the received signal and inhibits interference of adjacent-channel signals, no second intermediate-frequency filter is needed; therefore, the receiver of the present invention can be miniaturized accordingly.

Moreover, even if the second intermediate-frequency filter is employed, an active filter, switched capacitor filter or similar filter can be used with ease, since the requirement for the selectivity characteristic of the second intermediate-frequency filter is not severe. This facilitates fabrication of the second intermediate-frequency filter as an IC, making it possible to further miniaturize the receiver and further enhancement of its sensitivity. Besides, the second intermediate-frequency filter eliminates noise which is contained in the output signal of the second frequency converter, such as a leak of the output signal of the second local oscillator -- this prevents the limiter amplifier of the subsequent stage from saturation by out-of-band noise, providing for increased receiving sensitivity. In this instance, interference of adjacent-channel signals is inhibited by the first intermediate-frequency filter and the level of noise in the output signal from the second frequency converter is lower than the interference of adjacent-channel signals; so that the second intermediate-frequency filter, formed by a micro-miniature ceramic filter or chip type low-pass filter composed of laminated LC elements, is capable of sufficiently suppressing noise. Thus, the both requirements for miniaturization of the receiver and enhancement of its sensitivity can be satisfied. The first intermediate-frequency signal may also be converted directly to a base band. In such an instance, the low-pass filter of the base band is so low in operating frequency that it is suitable for fabrication as an IC and consumes less power.

By reduction of power dissipation and miniaturization of the receiver, the application of diversity reception becomes easy even in the field of the portable telephone which is severely required to be small in size and low in power dissipation. Hence, the sensitivity of the receiver can be increased and excellent channel quality can be secured.

It will be apparent that many modifications and variations may be effected without departing from the scope of the novel concepts of the present invention.

## Claims

1. A receiver for digital mobile radio communications, comprising:
first local oscillator means for generating a first local signal;
first frequency converter means for mixing said first local signal with a received digital phase-modulated signal to obtain a first intermediate-frequency signal;
first intermediate-frequency filter means which has an approximate square-root Nyquist cosine roll-off characteristic for suppressing intersymbol interference of said first intermediate-frequency signal from said first frequency converter means and a channel filtering characteristic for suppressing interference of adjacent-channel signals;
second local signal generator means for generating a second local signal;
second frequency converter means for mixing said first intermediate-frequency signal from said first intermediate-frequency filter means with said second local signal to obtain a signal of a desired frequency lower than that of said first intermediate-frequency signal; and
demodulator means for demodulating the output from said second frequency converter means.

2. The receiver of claim 1, wherein said signal of said desired frequency is a second intermediate-frequency signal and said second frequency converter means includes second intermediate-frequency filter means for suppressing out-of-band noise of said second intermediate-frequency signal.

3. The receiver of claim 1, wherein said local signal generator means includes local oscillator means for generating said second local signal of a frequency equal to the center frequency of said first intermediate-frequency signal and phase shifter means for shifting the phase of said second local signal, and wherein said second frequency converter means includes first and second mixer means supplied with the output from said local oscillator means and the output from said phase shifter means, respectively, for converting the output from said first intermediate-frequency filter means to base band signals, and first and second low-pass filter means supplied with the outputs from said first and second mixer means, for suppressing out-of-band noise of said base band signals, the outputs from said first and second low-pass filter means being applied to said demodulator means.

4. The receiver of claim 1, 2, or 3, wherein said first intermediate-frequency filter means is formed by a fundamental resonance mode monolithic crystal filter.

5. The receiver of claim 2, wherein said second intermediate-frequency filter means is formed by a ceramic filter.
